# EUROPEAN PATENT SPECIFICATION

(11) **EP 3 352 233 B1**
(45) Date of publication and mention of the grant of the patent: **04.03.2020**
(21) Application number: 16846498.0
(22) Date of filing: 14.09.2016
(51) Int. Cl.: H01L 35/08, H01L 35/34

(54) **THERMOELECTRIC CONVERSION MODULE AND THERMOELECTRIC CONVERSION DEVICE**
MODUL ZUR THERMOELEKTRISCHEN UMWANDLUNG UND VORRICHTUNG ZUR THERMOELEKTRISCHEN UMWANDLUNG
MODULE DE CONVERSION THERMOÉLECTRIQUE ET DISPOSITIF DE CONVERSION THERMOÉLECTRIQUE

(30) Priority: 18.09.2015 JP 2015185995; 31.08.2016 JP 2016168783
(43) Date of publication of application: 25.07.2018
(73) Proprietor: Mitsubishi Materials Corporation, Chiyoda-ku Tokyo 100-8117 (JP)
(72) Inventor: OI, Sotaro, Saitama-shi Saitama 330-8508 (JP); NISHIMOTO, Syuuji, Saitama-shi Saitama 330-8508 (JP); KOMASAKI, Masahito, Saitama-shi Saitama 330-8508 (JP); IWAZAKI, Wataru, Saitama-shi Saitama 330-8508 (JP)
(74) Representative: Hoffmann Eitle
(86) International application number: PCT/JP2016/077080
(87) International publication number: WO 2017/047627

(56) References cited:
- WO-A1-2009/008127
- JP-A- H06 342 940
- JP-A- 2006 034 046
- JP-A- 2009 117 792
- JP-A- 2011 061 031
- JP-A- 2011 198 989
- JP-A- 2012 231 024
- JP-A- 2015 018 986
- US-A- 4 436 785
- US-A- 4 962 066
- US-A1- 2011 017 254
- US-B1- 6 492 585

## Description

### BACKGROUND OF THE INVENTION

### Technical Field

The present invention relates to a thermoelectric conversion module in which P-type thermoelectric conversion elements and N-type thermoelectric conversion elements are combined and arranged and a thermoelectric conversion device in which the thermoelectric conversion module is utilized.

### Background Art

A thermoelectric conversion module has a structure in which a plurality of combinations in which a pair of a P-type thermoelectric conversion element and an N-type thermoelectric conversion element are connected with each other at electrodes are electrically connected in series by arranging them in alternate order of P, N, P, N between a pair of wiring substrates. In such thermoelectric conversion module, when both the ends are connected to DC power source, heat is moved in each thermoelectric conversion element by a Peltier effect (the heat is moved in a same direction with the current in the P-type element, and in an opposite direction to the current in the N-type element). Alternatively, by arranging the thermoelectric conversion module in a state in which one of the wiring substrates is at a higher-temperature side and the other is at a lower-temperature side so as to apply difference in temperature between the wiring substrates, electromotive force is generated in each thermoelectric conversion element by a Seebeck effect. Accordingly, the thermoelectric conversion module can be used for cooling, heating, or generating electric power.

As such a thermoelectric conversion module, for example, Patent Document 1 discloses a thermoelectric conversion module using a wiring substrate in which an electrode is bonded on one surface of an insulate substrate. As the insulate substrate, other than a resin substrate, a ceramic substrate such as aluminum nitride or the like is described as an example. As the electrode, one which is made of copper, silver, silver-palladium or the like is described as an example. Solder is used for joining the electrode of the wiring substrate and the thermoelectric conversion element.

Patent Document 2 discloses that because an insulate substrate is made of material having a small linear expansion coefficient, a linear cut portion is formed on an outer surface of an insulate substrate in order to prevent a breakage owing to thermal strain.

Patent Document 3 discloses that an intermediate layer made of titanium or titanium alloy is provided between an electrode and a thermoelectric conversion element in order to prevent material of the electrode from dispersing into the thermoelectric conversion element at high temperature.
US 6 492 585 B1 discusses providing a solderless thermoelectric device using metal filled glass instead of solder for coupling plates to thermoelectric elements. This document discusses interconnects created using silver filled glass compound, copper, aluminum or other electrically conductive material.
US 2011 0 017 254 A1 discusses improving thermoelectric modules by improving the connection of the thermoelectric material legs to electrically conductive contacts by the use of solder materials preferably selected from silver and copper or alloys thereof.

### Citation List

Patent Document 1: Japanese Unexamined Patent Application, First Publication No. 2014-123596
Patent Document 2: Japanese Unexamined Patent Application, First Publication No. 2008-16598
Patent Document 3: Japanese Unexamined Patent Application, First Publication No. 2006-49736

### SUMMARY OF INVENTION

### Technical Problem

In the thermoelectric conversion module in which the electrode and the thermoelectric conversion element are soldered as disclosed in Patent Document 1, if usage temperature is high (e.g., 300°C to 500°C), a solder layer is softened, so there is a problem of joint reliability may be deteriorated.

Accordingly, it is considered to use a joint layer made of metal which is not softened even at high temperature as a main ingredient instead of solder though, there may be problem of breakage in the ceramic substrate. However, if the cut portion is formed on the insulate substrate as disclosed in Patent Document 2 for measures, there may be a problem that the cut portion may be a starting point of the breakage.

Moreover, it is also necessary to have measures for the problem of the dispersion of the electrode material described in Patent Document 3.

The present invention is achieved in consideration of the above circumstances, and has an object to firmly join a thermoelectric conversion element and an electrode, prevent a breakage of a ceramic substrate from generating, and further prevent a dispersion of electrode material into the thermoelectric conversion element, and improve a reliability.

### Solution to Problem

The mentioned problems are solved by the subject-matter of the independent claims.

A thermoelectric conversion module according to an aspect includes a pair of opposing wiring substrates; a plurality of thermoelectric conversion elements connected via the wiring substrates between the wiring substrates; ceramic substrates provided at the respective wiring substrates; electrode layers made of aluminum or aluminum alloy, provided at the respective wiring substrates, formed on one surface of the respective ceramic substrates and connected to the thermoelectric conversion elements; and a silver base layer formed on a surface of the electrode layers at at least one of the wiring substrates, and connected to the thermoelectric conversion elements.

Since the silver base layer is not softened even at high temperature, joint reliability is excellent. Accordingly, using the wiring substrates having the silver base layer at higher-temperature side, excellent thermal resistance can be shown. In this case, if copper or copper alloy is used for the electrode layers as described in Patent Document 1, since copper has large deformation resistance, the ceramic substrates are easy to be broken by thermal stress. However, since the electrode layers are made of aluminum or aluminum alloy having smaller deformation resistance than copper, the thermal stress on the ceramic substrates can be reduced and the breakage can be prevented.

Moreover, since the silver base layer is formed on the electrode layer, dispersion of an aluminum ingredient in the electrode layers into the thermoelectric conversion elements can be prevented, so that it is possible to maintain high reliability for a long term.

In the thermoelectric conversion module according to an aspect, the silver base layer may be structured from a glass layer formed on any of the electrode layers and a silver layer made of a fired body of silver laminated on the glass layer.

The glass layer on any of the surfaces of the electrode layers is reacted with an oxide coat film on any of the surfaces of the electrode layers, so that the oxide coat film can be removed from the surfaces of the electrode layers. As a result, the electrode layers and the thermoelectric conversion elements can be more reliably joined.

In the thermoelectric conversion module according to an aspect, it is preferable that metallized layers made of any one of gold, silver or nickel be formed on the thermoelectric conversion elements at each of end surfaces to which the electrode layers are joined. By the metallized layers, the end surfaces of the thermoelectric conversion elements can be joined more firmly to the electrode layers.

In the thermoelectric conversion module according to an aspect, the silver base layer is joined to the metallized layers on the thermoelectric conversion elements, directly or with interposing a silver joint layer made of a silver fired body therebetween.

When the silver base layer and the metallized layer on the thermoelectric conversion element are joined directly; solder material or the like is not arranged therebetween, so that the electrode layers and the thermoelectric conversion elements are reliably joined; because any joint material is not melted between the electrode layers and the thermoelectric conversion elements, even though these are used under high temperature environment. Accordingly, it can be used stably even under the high temperature environment. On the other, when the silver joint layer is interposed, it is possible to join them more firmly since the silver joint layer and the silver base layer are metal of the same kind.

In the thermoelectric conversion module according to an aspect, it is preferable that barrier layers made of nickel or titanium be formed between the end surfaces of the thermoelectric conversion elements and the metallized layers when the metallized layers are made of gold or silver. When the metallized layers are made of gold or silver, there is a slight risk of dispersion of gold or silver into the thermoelectric conversion elements though, it can be prevented by these barrier layers reliably, so that it is possible to maintain the performance of the thermoelectric conversion elements to be excellent.

In the thermoelectric conversion module according to an aspect, it is preferable that the electrode layers be made of aluminum with purity 99.99 mass% or higher.

Since deformation resistance of aluminum with purity 99.99 mass% or higher (so called 4N aluminum) is further smaller, it is possible to absorb thermal strain at high temperature and reliably prevent the breakage of the ceramic substrates.

In the thermoelectric conversion module according to an aspect, it is preferable that heat-transfer metal layers be joined on the other surfaces of the respective ceramic substrates.

Providing the heat-transfer metal layers, it is possible to improve heat transmission; and a symmetrical structure of two-surfaces centering the ceramic substrates can be formed since the electrode layer is disposed on the one surface and the heat-transfer metal layer is disposed on the other surface of the respective ceramic substrates. Accordingly, it is possible to prevent the wiring substrates from warping, improve ease of assembly into the thermoelectric conversion module, and improve long term reliability.

A thermoelectric conversion module with heat sink may include the thermoelectric conversion module, an endothermic heat sink joined on the heat-transfer metal layer on one of the wiring substrates; and a radiation heat sink joined on the heat-transfer metal layer on the other of the wiring substrates. Furthermore, a thermoelectric conversion device may include the thermoelectric conversion module with heat sink and a liquid cooling cooler fixed on the radiation heat sink.

### Advantageous Effects of Invention

According to the present invention, since the silver base layer is formed on the electrode layers and joined to the thermoelectric conversion elements, the joint reliability is excellent, the dispersion from the material of the electrode layers into the thermoelectric conversion elements can be prevented. Furthermore, since the deformation resistance of the electrode layers is small, the breakage of the ceramic substrates can be prevented, and the thermoelectric conversion module having long-term high reliability can be obtained.

### BRIEF DESCRIPTION OF DRAWINGS

[FIG. 1] It is a vertical sectional view showing a thermoelectric conversion module of a first embodiment.
[FIG. 2] It is a plan sectional view in an arrow-view direction along the A-A line in FIG. 1.
[FIG. 3] It is a plan sectional view in an arrow-view direction along the line B-B in FIG. 1.
[FIG. 4] It is an enlarged sectional view in a vicinity of a joint part between an electrode layer of a wiring substrate and a thermoelectric conversion element in FIG. 1.
[FIG. 5] It is an enlarged sectional view showing a joint state of a silver base layer to the electrode layer.
[FIG. 6] It is a graph simplifying a change of a warp of the thermoelectric conversion module along with temperature change in usage.
[FIG. 7] It is a vertical sectional view showing a thermoelectric conversion module of a second embodiment.
[FIG. 8] It is an enlarged sectional view in a vicinity of a joint part between an electrode layer of a wiring substrate and a thermoelectric conversion element in FIG. 7.
[FIG. 9] It is a vertical sectional view showing an example of a thermoelectric conversion device in which heat sinks are mounted on a thermoelectric conversion module.

### DESCRIPTION OF EMBODIMENTS

Embodiments will be explained below with referring drawings.

### ---Overall Structure of Thermoelectric Conversion Module---

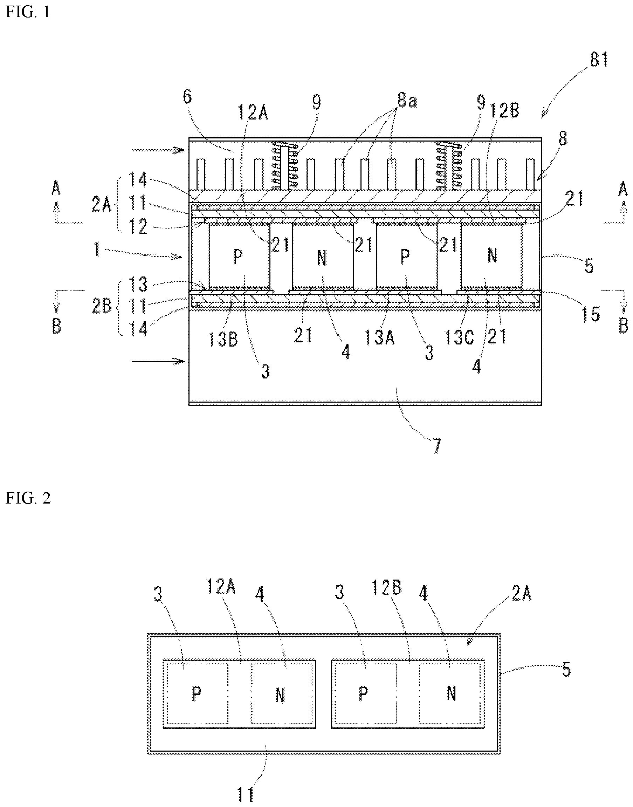

First, a thermoelectric conversion module according to a first embodiment will be described. The thermoelectric conversion module 1 of the present embodiment has a structure in which P-type thermoelectric conversion elements 3 and N-type thermoelectric conversion elements 4 are arranged in line (in one dimensional) or in plane (in two dimensional) between a pair of wiring substrates 2A, 2B facing each other, as shown in FIG. 1 to FIG. 3. To simplify, FIG. 1 to FIG. 3 show an example in which two pairs of the P-type thermoelectric conversion elements 3 and the N-type thermoelectric conversion elements 4 are arranged, so that four thermoelectric conversion elements 3, 4 in total are aligned in line. In the drawings, "P" denotes the P-type thermoelectric conversion elements 3, and "N" denotes the N-type thermoelectric conversion elements 4. The thermoelectric conversion module 1 is put in a case 5 entirely, and mounted between a higher-temperature channel 6 in which high temperature gas flows and a lower-temperature channel 7 in which cooling water flows so as to structure a thermoelectric conversion device 81.

In the higher-temperature channel 6, a heat sink 8 having rod-like fins 8a and elastic members 9 such as a spring pressing the heat sink 8 toward the wiring substrate 2A and making the heat sink 8 into contact with the wiring substrate 2A are provided.

### ---Detailed Structure of Wiring Substrate, Thermoelectric Conversion Element, and Joint Part of Them---

In the respective wiring substrates 2A, 2B, each of electrode layers 12, 13 is formed on one surface of respective ceramic substrates 11 and each of heat-transfer metal layers 14 is formed on the other surface of the respective ceramic substrates 11. For the ceramic substrates 11, aluminum nitride (AlN), alumina (Al2O3), silicon nitride (Si3N4), silicon carbide (SiC), an insulate ceramic substrate having high thermal conductivity such as a diamond thin-film substrate or the like, in which a film is formed on a carbon plate or a graphite plate, are used. Thickness of the ceramic substrates 11 is 0.2 mm to 1.5 mm.

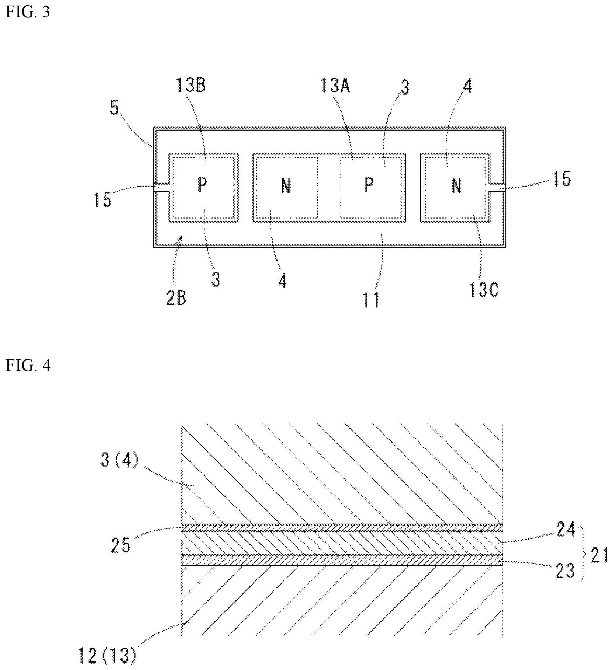

The electrode layer 12 is formed on a first wiring substrate 2A which is one wiring substrate shown in an upper part of FIG. 1. The electrode layer 12 is structured from two electrode parts 12A, 12B, which are rectangle in plan view as shown in FIG. 2. The electrode parts 12A, 12B each connect the adjacent P-type thermoelectric conversion element 3 and the N-type thermoelectric conversion element 4 in the respective pairs. An electrode part 13A, 13B, and 13C are formed on a second wiring substrate 2B which is the other wiring substrate shown in a lower part of FIG. 1. As shown in FIG. 3, among the thermoelectric conversion elements 3, 4 of the respective pairs connected by the electrode layer 12 of the first wiring substrate 2A, the N-type thermoelectric conversion element 4 of the one pair and the P-type thermoelectric conversion element 3 of the other pair are connected by the electrode part 13A. The electrode part 13A is disposed at a center part of a row of the thermoelectric conversion elements 3, 4. The electrode parts 13B, 13C are disposed at two end of the row respectively, and each connected to the P-type thermoelectric conversion element 3 of the one pair and the N-type thermoelectric conversion element 4 of the other pair. The electrode layer 13 is structured from these three electrode parts 13Ato 13C. Outer wiring parts 15 are formed at the respective electrode parts 13B, 13C formed on both the ends integrally or by welding other parts.

These electrode layers 12, 13 are made of aluminum or aluminum alloy, and formed by being joined on surfaces of the ceramic substrates 11. For material of the electrode layers 12, 13, aluminum with purity 99.99 mass% or higher (so-called 4N aluminum) is desirable. Sizes (areas) of the electrode parts 12A, 12B, 13A to 13C are set to be slightly larger than an area of an end surface of each of the thermoelectric conversion elements 3, 4 in accordance with sizes of the thermoelectric conversion elements 3, 4 connected to these electrode parts. Thickness of the electrode layers 12, 13 is set to be 0.05 mm to 2.0 mm.

Similarly to the electrode layers 12, 13, the heat-transfer metal layers 14 are made of aluminum or aluminum alloy, and formed by being joined on the surfaces of the ceramic substrates 11. For material, aluminum with purity 99.99 mass% or higher (so-called 4N aluminum) is desirable. Thickness is not limited, but it is desirable to set the same thickness as the electrode layers 12, 13.

These electrode layers 12, 13 and the heat-transfer metal layers 14 are joined to the ceramic substrates 11 by brazing or the like.

A silver base layer 21 is formed on respective surfaces of the electrode layers 12, 13. End surfaces of the thermoelectric conversion elements 3, 4 are connected to the silver base layers 21.

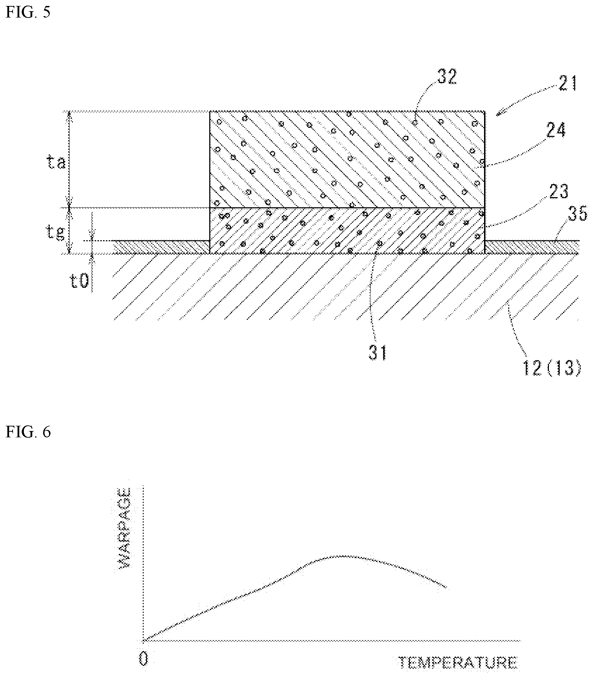

The silver base layers 21 are formed by applying a glass-included silver paste on the surfaces of the electrode layers 12, 13 and firing them. As shown in FIG. 4 and FIG. 5, the silver base layers 21 have a double-layer structure of a glass layers 23 formed at the electrode layers 12, 13 sides and silver layers 24 formed on the glass layers 23 respectively. Inside the glass layers 23, fine conductive particles 31 with particle diameter about several nanometer are dispersed. The conductive particles 31 are crystalline particles including at least one of silver or aluminum. The conductive particles 31 in the glass layers 23 can be observed by using a transmission electron microscope (TEM), for example. Also inside the silver layers 24, fine glass particles 32 with a mean particle diameter about several nanometer are dispersed.

When the electrode layers 12, 13 are structured from aluminum with purity 99.99 mass% or higher, naturally generated aluminum oxide films 35 in the air are formed on the surfaces of the electrode layers 12, 13. However, in parts in which the above-described silver base layers 21 are formed, the aluminum oxide films 35 are removed by forming of the glass layers 23, so that the silver base layers 21 are formed directly on the electrode layers 12, 13. That is to say, as shown in FIG. 5, the aluminum forming the electrode layers 12, 13 and the glass layers 23 of the silver base layers 21 are directly joined.

In the present embodiment, as shown in FIG. 5, a thickness t0 of the aluminum oxide films 35 which are naturally generated on the electrode layer 12, 13 is set in a range of 1 nm ≤ t0 ≤ 6 nm. A thickness tg of the glass layers 23 is set in a range of 0.01 µm ≤ tg ≤ 5 µm. A thickness ta of the silver layers 24 is set in a range of 1 µm ≤ ta ≤ 100 µm. A thickness of the entire silver base layers 21 is set to 1.01 µm to 105 µm. In the silver layers 24, a volume density of silver is 55% to 90% and a volume density of glass is 1% to 5%; and the remnant is pores.

An electrical resistivity P of the silver base layers 21 in a thickness direction is less than 0.5 Ω. In the present embodiment, the electrical resistivity P of the silver base layers 21 in the thickness direction is an electrical resistivity between surfaces of the silver base layers 21 (surfaces of the silver layers 24) and surfaces of the electrode layers 12, 13. This is because an electrical resistance of aluminum (4N aluminum) forming the electrode layers 12, 13 is far smaller comparing with an electrical resistance of the silver base layers 21 in the thickness direction. When measuring the electrical resistance, an electrical resistance is measured between a surface center point of the silver base layers 21 and a point on the electrode layers 12, 13; the point is away from a peripheral edge of the silver base layers 21 with a same distance, as a distance from the surface center point of the silver base layers 21 to the peripheral edge of the silver base layers 21 along a surface direction.

For material of the P-type thermoelectric conversion elements 3 and the N-type thermoelectric conversion element 4, silicide-based material, oxide-based material, skutterudite (intermetallic compound of transition metals and pnictogens), half whistlers and the like can be used. Particularly, silicide-based material has small influence on environment, is rich in reserves, and thus notable; manganese silicide (MnSi_{1.73}) is used for the P-type thermoelectric conversion elements 3, and magnesium silicide (Mg₂Si) is used for the N-type thermoelectric conversion elements 4. These thermoelectric conversion elements 3, 4 are formed into square pillars or the like in which a cross section thereof is a square (e.g., 1 mm to 8 mm on a side); and a length thereof (along a direction in which the wiring substrates 2A, 2B face each other) is 2 mm to 8 mm. On both the end surfaces of the thermoelectric conversion elements 3, 4. metallized layers 25 including any layer of nickel, silver and gold are formed. When the metallized layers 25 are made of silver or gold, barrier layers 26 are formed from a single layer or a stacked structure of nickel or titanium between the metallized layers 25 and the thermoelectric conversion elements 3, 4. If the metallized layers 25 are made of silver, it is possible to obtain more excellent joint state because it is a joint with the same kind of metal as the silver base layers 21.

A manufacturing method of the thermoelectric conversion module 1 structured as above will be explained.

### ---Manufacturing Wiring Substrate---

By the Al-Si based brazing material or the like, bonding the electrode layers 12, 13 on the one surfaces of the ceramic substrates 11, and bonding the heat-transfer metal layers 14 on the other surfaces of the ceramic substrates 11, so that the wiring substrates 2A, 2B are obtained. Specifically, stacking aluminum plates to be the electrode layers 12, 13 and aluminum plates to be the heat-transfer metal layers 14 on the ceramic substrates 11 with the brazing material therebetween, and heating them to 610°C to 650°C with pressurizing in a stacked direction, the electrode layers 12, 13 and the heat-transfer metal layers 14 are joined to the ceramic substrates 11.

In this case, the ceramic substrates 11 have different thermal expansion coefficient from that of electrode layers 12, 13 and the heat-transfer metal layers 14, so thermal strain is easy to generated on joint parts therebetween. However, since the electrode layers 12, 13 and the heat-transfer metal layers 14 are made of aluminum or aluminum alloy, the thermal strain can be absorbed. Moreover, since the electrode layers 12, 13 and the heat-transfer metal layers 14 are symmetrically provided with interposing the ceramic substrates 11, it is possible to prevent warp from generating.

### ---Forming Silver Base Layer---

Next, the silver base layers 21 are formed by applying a glass-included silver paste on the electrode layers 12, 13 and firing it.

The glass-included silver paste includes silver powder, glass (non-lead glass) powder, resin, a solvent and a dispersant. A content of a powder ingredient made of the silver powder and the glass powder is not lower than 60 mass% and not higher than 90 mass% of the entire glass-included silver paste; and remnants thereof are the resin, the solvent and the dispersant. The silver powder has a particle diameter not smaller than 0.05 µm and not larger than 1.0 µm; desirably, a mean particle diameter 0.8 µm, for example. The glass powder includes any one of or two or more of bismuth oxide (Bi₂O₃), zinc oxide (ZnO), boron oxide (B₂O₃), lead oxide (PbO₂), and phosphorus oxide (P₂O₅) as a main ingredient: and glassy-transition temperature thereof is not lower than 300°C and not higher than 450°C; softening temperature thereof is 600°C or lower; and crystallization temperature is 450°C or higher. For example, glass powder including lead oxide, zinc oxide and boron oxide with a mean particle diameter 0.5 µm is suitable.

Where a weight of the silver powder is A and a weight of the glass powder is G; weight ratio A/G is controlled within a range of 80/20 to 99/1, e.g., A/G = 80/5.

The solvent having a boiling point 200°C or higher is suitable, e.g., diethylene glycol dibutyl ether is used.

The resin controls viscosity of the glass-included silver paste; it is suitable to be decomposed at 350°C or higher. For example, ethyl cellulose is used.

If necessary, dicarboxylic acid-based dispersant is added. It is acceptable to form the glass-included silver paste without adding the dispersant.

The glass-included silver paste is manufactured by premixing mixed powder of the silver powder and the glass powder and an organic compound in which a solvent and resin is mixed by a mixer with a dispersant, and further mixing the obtained pre-mixture with kneading by a roll-mill machine, and then filtrating the kneaded mixture by a paste filtering machine. The glass-included silver paste is controlled to have viscosity 10 Pa·s or higher and 500 Pa·s or lower; more preferably, 50 Pa·s or higher and 300 Pa·s or lower.

The glass-included silver paste is applied on the electrode layers 12, 13 by a screen printing or the like; after drying, it is fired at temperature 350°C or higher and 645°C or lower for not shorter than 1 minute and not longer than 60 minutes. When the glass layers 23 are formed, the aluminum oxide films 35 naturally generated on the surfaces of the electrode layers 12, 13 are melted and removed; so that the glass layers 23 are directly formed on the electrode layers 12, 13, and the silver layers 24 are formed on the glass layers 23. The glass layers 23 are firmly adhered to the electrode layers 12, 13, accordingly the silver layers 24 are reliably maintained and fixed on the electrode layers 12, 13.

As described above, the conductive particles (the crystalline particles) 31 including at least one of silver and aluminum are dispersed in the glass layers 23, guessed to be precipitated into the glass layers 23 while firing. The fine glass particles 32 are dispersed also inside the silver layers 24. The glass particles 32 are guessed that remained glass component was condensed while the silver particles were fired.

In this embodiment, heat treatment requirements for forming the silver base layers 21 are in a range of a heating temperature between 350°C to 645°C inclusive, and in a range of a holding time at the heating temperature between 1 minute to 60 minutes inclusive. By performing the heat treatment with these requirements, the mean crystalline particle diameter of the silver layers of the silver base layers formed after the heat treatment is controlled to a range between 0.5 µm to 3.0 µm inclusive.

In a case in which the heating temperature is lower than 350°C and the holding time at the heating temperature is shorter than 1 minute, the silver base layers 21 are not enough fired and it may not be possible to be formed enough. In a case in which the heating temperature is higher than 645°C and a case in which the holding time at the heating temperature is longer than 60 minutes, the firing is too much advanced, and it is possibly that the mean crystalline particle diameter of the silver layers 24 in the silver base layers 21 formed after the heat treatment be out of the range between 0.5 µm to 3.0 µm inclusive.

In order to form the silver base layers 21 reliably, it is preferable that a lower limit of the heating temperature in the heat treatment be equal to or higher than 400°C; more preferably, equal to or higher than 450°C. The holding time at the heating temperature is preferably 5 minutes or longer; more preferably, 10 minutes or longer.

In order to reliably restrain the firing from advancing, it is preferable that the heating temperature in the heat treatment be equal to or lower than 600°C; more preferably, equal to or lower than 575°C. It is preferable that the holding time at the heating temperature be equal to or shorter than 45 minutes; more preferably, equal to or shorter than 30 minutes.

### ---Manufacturing Thermoelectric Conversion Element---

The thermoelectric conversion elements 3, 4 are manufactured, for example, by the following steps of: making mother alloys of manganese silicide (MnSi_{1.73}) and magnesium silicide (Mg₂Si) respectively, which are the silicide-based materials; powdering the mother alloys by a ball milling machine, into particle diameters 75 µm or smaller for example; making bulk materials having a shape of, for example, a disk, a rectangle plate and the like by a spark plasma sintering, a hot press, or a hot isotropic pressurizing; and cutting them into four-sided pillar for example. On the two end surfaces of the thermoelectric conversion elements 3, 4, the metallized layers 25 including any layer of nickel, silver, and gold and the barrier layers 26 as necessary are formed: the barrier layers 26 are formed from from a single layer of nickel or titanium or a stacking layer structure thereof. These metallized layers 25 and the barrier layers 26 are formed by plating, spattering and the like.

### ---Joining Process---

The P-type thermoelectric conversion elements 3 and the N-type thermoelectric conversion elements 4 are arranged in order between the wiring substrates 2A, 2B, so that the metallized layers 25 on the end surfaces of the thermoelectric conversion elements 3, 4 are pasted on the silver base layers 21 on the electrode layers 12, 13 of the wiring substrates 2A, 2B. In this state, in a heating furnace, it is heated under conditions of a pressure force in the stacking direction between 5 MPa to 40 MPa inclusive, the heating temperature between 200°C to 400°C inclusive, and the holding time at the heating temperature between 1 minute to 60 minutes inclusive; so that the silver layers 24 of the silver base layers 21 on the electrode layers 12, 13 are joined directly on the metallized layers 25 on the thermoelectric conversion elements 3, 4 by solid phase dispersion bonding.

In this case, there may be problems that bonding strength be not enough between the thermoelectric conversion elements 3, 4 and the electrode layers 12, 13 if the pressure force is less than 5 MPa; and the ceramic substrates 11 be broken if the pressure force is more than 40 MPa. It is more preferable that the pressure force be between 10 MPa and 35 MPa inclusive.

If the heating temperature is lower than 200°C and the holding time at the heating temperature is shorter than 1 minute, the bonding strength may not be enough between the thermoelectric conversion elements 3, 4 and the electrode layers 12, 13. In a case in which the heating temperature is higher than 400°C and a case in which the holding time at the heating temperature is longer than 60 minutes, a quality of the thermoelectric conversion elements 3, 4 may be deteriorated by the heat.

As described above, it is integrated so that the P-type thermoelectric conversion elements 3 and the N-type thermoelectric conversion elements 4 are connected in series between the wiring substrates 2A, 2B. This integrated object in which the thermoelectric conversion elements 3, 4 are joined between the wiring substrates 2A, 2B is put in the case 5 made of stainless steel or the like air-tightly and packaged to maintain a vacuum state or a decompressed state inside, so that the thermoelectric conversion module 1 is manufactured. The outer wiring parts 15 are drawn out with insulting to the case 5. In addition, the case 5 is not always necessary; the case 5 does not need to be provided.

In the thermoelectric conversion module 1 as structured above, the wiring substrate (the first wiring substrate) 2A, which is the one of the wiring substrates 2A, 2B, is in contact with the higher-temperature channel 6 as an external heat source in which the high-temperature fluid of temperature 300°C to 500°C such as an exhaust gas or the like of an internal combustion engine flows as shown by the arrow in an illustrated example case: the other wiring substrate (the second wiring substrate) 2B is in contact with the lower-temperature channel 7 in which cooling water of temperature 80°C to 100°C flows as thermal medium. Thereby generating an electromotive force on the thermoelectric conversion elements 3, 4 in accordance with the temperature difference between the wiring substrates 2A, 2B, it is possible to obtain potential difference which is a total of the electromotive forces generated in the thermoelectric conversion elements 3, 4, between the outer wiring parts 15 at both the ends of the row.

In the thermoelectric conversion module 1 of this embodiment, the electrode layers 12, 13 of the wiring substrates 2A, 2B and the heat-transfer metal layers 14 are made of aluminum or aluminum alloy having the small deformation resistance, so that it is possible to reduce the thermal stress on the ceramic substrates 11 and prevent the breakage. Moreover, the heat-transfer metal layers 14 and the electrode layers 12, 13 are disposed symmetrically in two sides of the ceramic substrates 11 with interposing the ceramic substrates 11, so that the warpage of these while bonding reduced and it is easy to assemble the thermoelectric conversion elements 3, 4 after that.

Since the thermoelectric conversion elements 3, 4 are joined on the electrode layers 12, 13 by the silver base layers 21, the silver base layers 21 are not softened unlike the solder even when it is used at high temperature, so that the bonding reliability is good.

Since the silver base layers 21 are interposed between the electrode layers 12, 13 and the thermoelectric conversion elements 3, 4, the aluminum ingredient in the electrode layers 12, 13 is prevented from dispersing into the thermoelectric conversion elements 3, 4, so that high reliability can be maintained for a long term.

The thermoelectric conversion module 1 has the high reliability because the warpage is reduced against the temperature change when it is used.

FIG. 6 shows a model of warp change in the thermoelectric conversion module 1 along with the temperature change when it is used. As described above, since the wire substrates 2A, 2B are assembled in a state in which the warpage is prevented, the warpage of the thermoelectric conversion module 1 is almost "0" in the room temperature. If a fluid of 300°C to 500°C flows in the higher-temperature channel 6 and a fluid of 80°C to 100°C flows in the lower-temperature channel 7, there may be a warpage along with a rise in temperature on the thermoelectric conversion module 1 by temperature distribution between the back and front of the wiring substrate (the first wiring substrate) 2A particularly at the higher-temperature side. However, since the electrode layers 12 and the heat-transfer layers 14 are both made of aluminum or aluminum alloy, it is possible to reduce the warpage because it is softened at high temperature. Accordingly, this thermoelectric conversion module 1 can maintain a stable performance for a long therm.

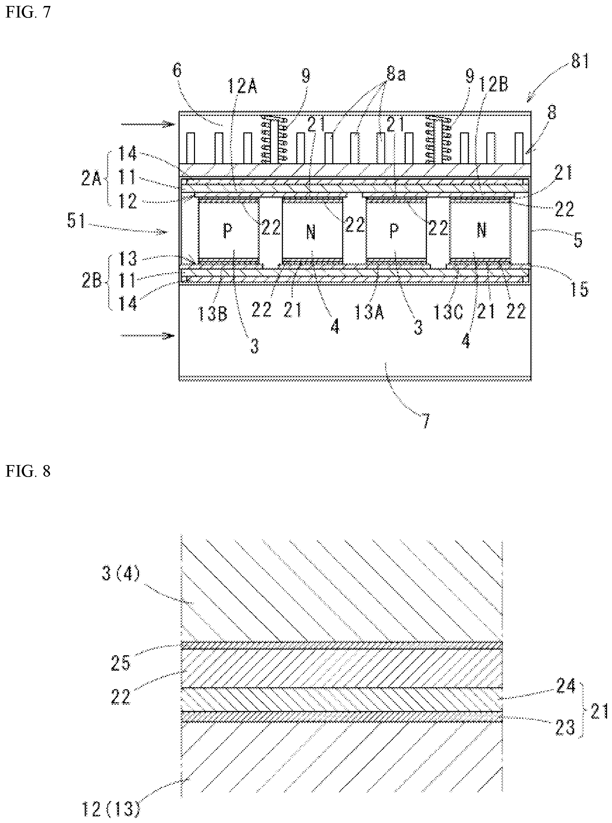

FIG. 7 and FIG. 8 shows a second embodiment. In the above-described first embodiment, the silver base layers 21 formed on the electrode layers 12, 13 and the end surfaces of the thermoelectric conversion elements 3, 4 (the metallized layers 25) are joined directly. In a thermoelectric conversion module 51 of this second embodiment, a silver joint layer 22 is further formed on the respective silver base layers 21; and the thermoelectric conversion elements 3, 4 are joined by the silver joint layers 22. Below, the same parts as the first embodiment are denoted by the same reference symbols and the explanation thereof is simplified.

The silver joint layers 22 are fired bodies of silver formed by firing silver particles; it is formed by applying a silver paste made of silver powder, resin and the like and heating it. The silver joint layers 22 have a volume density of silver 55% to 95%; and remnant thereof is pores. A thickness thereof is 5 µm to 50 µm.

In the silver joint layers 22, the glass particles 32 observed in the silver layers 24 of the silver base layers 21 do not exist, or very few even if it exists.

In order to join the thermoelectric conversion elements on the electrode layers 12, 13 by the silver joint layers 22, first, a silver paste is applied on the silver base layers 21 on the electrode layers 12, 13 of the wiring substrates 2A, 2B. The silver paste includes silver powder of particle diameter 0.05 µm to 100 µm, resin, and a solvent.

Ethyl cellulose or the like can be used for the resin in the silver paste. α-terpineol or the like can be used for the solvent in the silver paste.

As composition of the silver paste, it is preferable that, with respect to the whole silver paste; content of the silver powder be 60 mass% to 92 mass% inclusive, content of the resin be 1 mass% to 10 mass% inclusive, and the remnant be the solvent.

It is acceptable that organic metal compound powder such as carboxylic acid-based metal salt and the like such as formic aced-silver, silver acetate, propionic acid-silver, benzoic acid-silver, silver oxalate be included at 0 mass% to 10 mass% inclusive in the silver paste with respect to the whole silver paste. As necessary, it is acceptable that a reducing agent such as alcohol, organic acid or the like be included in the whole silver paste with 0 mass% to 10 mass% inclusive. The silver paste is controlled to have the viscosity 10 Pa·s to 100 Pa·s inclusive, more preferably, 30 Pa·s to 80 Pa·s inclusive.

After applying this silver paste on the silver base layers 21 on the electrode layers 12, 13 of the wiring substrate 2A, 2B by screen printing or the like and then drying it, the P-type thermoelectric conversion elements 3 and the N-type thermoelectric conversion elements 4 are arranged so as to lay the metallized layers 25 at the end surfaces of the thermoelectric conversion elements 3, 4 onto the silver paste layers, between the two wiring substrates 2A and 2B. In this state, in the heating furnace, it is heated and sintered at the pressure force in the stacking direction 0 MPa to 10 MPa inclusive, the heating temperature 150°C to 600°C inclusive, for 1 minute to 60 minutes inclusive. As a result, the electrode layers 12, 13 on which the silver base layers 21 are formed and the thermoelectric conversion elements 3, 4 are joined with interposing the silver joint layers 22.

In a case in which the thermoelectric conversion module is larger, if the thermoelectric conversion elements 3, 4 are directly joined on the silver base layers 21 on the electrode layers 12, 13, it may be difficult to control a flatness and a height of parts since a bonding property is affected by height unevenness of the parts. However, even in such a case, by joining the thermoelectric conversion elements 3, 4 on the silver base layers 21 on the surface of the electrode layers 12, 13 with interposing the silver joint layers 22 as in the thermoelectric conversion module 51 of this embodiment, it is possible to bond them stably.

The present invention is not limited to the above-described embodiments and various modifications may be made without departing from the scope of the present invention.

In the first embodiment, the thermoelectric conversion elements are joined to the wiring substrates at both the higher-temperature side and lower-temperature side with forming the silver base layers on the electrode layers. However, it is sufficient to form the silver base layers on the electrode layers at at least the higher-temperature side wiring substrate and bond the thermoelectric conversion elements. Also in the second embodiment, the thermoelectric conversion elements are bonded by the silver joint layers with forming the silver base layers on the electrode layers at the wiring substrates on both the higher-temperature side and lower-temperature side. However, it is sufficient to apply the structure to the joint parts of the thermoelectric conversion elements and the electrode layers at at least the higher-temperature side wiring substrate.

The silver base layers may include a layer of a silver foil bonded by brazing, solid phase diffusion or the like on the electrode layer, a layer made by silver plating, a layer made by silver spattering and the like, other than the structure made of the glass layer and the silver layer which are formed by firing as in the embodiments.

The electrode layer is formed on the one side of the ceramic substrate; and on the other side of the ceramic substrate the heat-transfer metal layer is formed: however, a structure having only the electrode layer may be acceptable.

The respective wiring substrates are in contact with the higher-temperature channel or the lower-temperature channel; however, it is not limited to the channel structure. It is sufficient to be in contact with a heat source and a cooling medium.

It is possible to manufacture a thermoelectric conversion module by arranging either one of the P-type or N-type thermoelectric conversion elements in a series connection state between a pair of the wiring substrates, unitizing the P-type or N-type respectively, and connecting the unit of the P-type thermoelectric conversion elements and the unit of the N-type thermoelectric conversion elements.

A rectangular shape, a round shape or the like may be applied other than a square for the flat surface shape of the electrode parts and the cross-sectional shape of the thermoelectric conversion elements.

In the second embodiment, in order to form the silver joint layer, an oxide silver paste can be used instead of the silver paste. The oxide silver paste includes oxide silver powder, reducing agent, resin, a solvent, and furthermore organic metal compound powder. With respect to the whole oxide silver paste, a content of the oxide silver powder is 60 mass% to 92 mass% inclusive; a content of the reducing agent is 5 mass% to 15 mass% inclusive; a content of the organic metal compound powder is 0 mass% to 10 mass%; and remnant thereof is the solvent.

By using the above-described oxide silver paste including the oxide silver and the reducing agent, it is possible to bond more harder because deoxidized silver particles precipitating by reducing the oxide silver while bonding (firing) are very fine, e.g., particle diameter 10 nm to 1 µm so that a minute silver joint layer is formed.

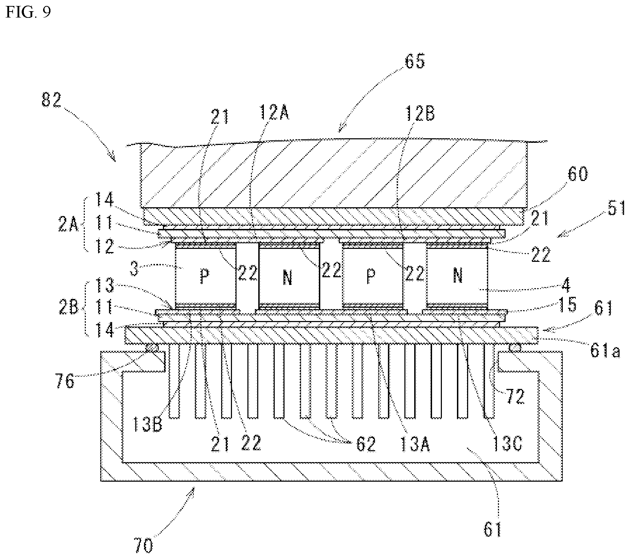

As another embodiment, as shown in FIG. 9, a structure in which a heat sink is joined to the thermoelectric conversion module 51 shown in FIG. 7 and so on may be acceptable. However, the case 5 is not used in FIG. 9.

Heat sinks 60, 61 are structured from an aluminum silicon carbide composite (AlSiC) or the like, formed by impregnating a porous body made of aluminum, aluminum alloy, copper, cooper alloy or silicon carbide with aluminum or aluminum alloy. The heat sinks may be provided with pin-shaped fins 62; or have a plate shape without the fins 62. In FIG. 9, the heat sink 60 having a flat-plate shape is provided at the higher-temperature side; and the heat sink 61 having the pin-shaped fins 62 is provided at the lower-temperature side. A thickness of the flat-plate shaped heat sink 60 and a thickness of a top plate 61a of the heat sink 61 having the pin-shaped fins 62 may be set to 0.5 mm to 8 mm respectively. In the example shown in FIG. 9, the flat-shaped heat sink 60 is provided at the one side of the thermoelectric conversion module 51; and the heat sink 61 having the fins 62 is provided at the other side.

At the higher-temperature side, the flat-plate shaped heat sink 60 is fixed being contact with a heat source 65 such as a furnace wall or the like; and at the lower-temperature side, the heat sink 61 having the fins 62 is fixed to a liquid cooling cooler 70 in which cooling water or the like can flow: so that a thermoelectric conversion device 82 is structured. The liquid cooling cooler 70 has a channel 71 formed inside, is fixed so that a periphery of an opening part 72 of a side wall is contact with the top plate 61a of the heat sink 61 so that the fins 62 are inserted in the channel 71 through the opening part 72. The reference symbol 76 denotes a seal member made of resin, disposed between the liquid cooling cooler 70 and the top plate 61a of the heat sink 61.

The heat-transfer metal layers 14 and the heat sinks 60, 61 are joined to each other by vacuum brazing using Al-Si brazing material or the like, brazing using flux in a nitrogen atmosphere, fluxless brazing using Al-based brazing material including Mg, solid phase diffusion bonding and the like. This structure enables to reduce thermal resistance between the thermoelectric conversion elements 3, 4 and the heat source 65 or thermal resistance between the thermoelectric conversion elements 3, 4 and the liquid cooling cooler 70.

### Examples

Next, experimental results for confirming effects will be explained.

Wiring substrates were made by bonding the electrode layers and the heat-transfer metal layers made of 4N-aluminum on ceramic substrates made of silicon nitride with a thickness 0.32 mm by the Al-Si based brazing material. The electrode layers and the heat-transfer metal layers had the same thickness 0.18 mm.

On the surfaces of the electrode layers, the glass-included silver paste was applied by screen printing and then fired in the air at 500°C to 550°C, so that the silver base layers with a thickness 10 µm were formed. Terminals made of copper were joined to electrode parts for external connecting of the electrode layers by ultrasonic welding.

The P-type thermoelectric conversion elements made of manganese silicide and the N-type thermoelectric conversion elements made of magnesium silicide were formed into the four-sided pillar shape respectively. On the end surfaces of the thermoelectric conversion elements the metallized layers made of silver were formed.

The thermoelectric conversion elements were disposed between the wiring substrates with stacking the end surfaces of the thermoelectric conversion elements on the silver base layers on the electrode layers, and these were fired in this state at the heating temperature 300°C, the pressurizing force 10 MPa, the holding time at the heating temperature 30 minutes in the air. As a result, a test sample (Example 1) of the thermoelectric conversion module in which the thermoelectric conversion elements having the metallized layers were directly joined to the silver base layers on the electrode layers was made. As another test sample, applying the silver paste described in the above embodiment on the silver base layers on the electrode layers by a dispenser, interposing the thermoelectric conversion elements between the wiring substrates so that the end surfaces of the thermoelectric conversion elements were stacked on the silver paste, and firing them in this state in the air at heating temperature 300°C, pressure force 10 MPa, and holding time at the heating temperature 30 minutes, so that a test sample (Example 2) of the thermoelectric conversion module in which the thermoelectric conversion elements having the metallized layers were joined to the silver base layers on the electrode layers with the silver joint layers therebetween was made.

As comparative examples, a test sample (Comparative Example 1) of a thermoelectric conversion module in which the thermoelectric conversion elements were joined to the surface of the electrode layers by the silver joint layers without forming the silver base layers was made; and a test sample (Comparative Example 2) in which the electrode layers were made of copper alloy, the silver base layers were made thereon and the thermoelectric conversion elements were joined thereon was made.

Regarding these test samples of the thermoelectric conversion modules, in a state after a 300 times cooling/heating cycle between -40°C to 300°C, joint states between the thermoelectric conversion elements and the electrode layers of the wiring substrates and presence of breakage on the ceramic substrates were observed; and changes of electric resistance between the two circuit layers compared to a first state after the firing were measured.

If any bonding defect such as separation and the like was not found at the joint part between the electrode layers and the thermoelectric conversion elements, it was regarded as "good": or if the bonding defect such as separation and the like was found, it was regarded as "poor".

Regarding change of electrical resistance, if the change rate after the cooling/heating cycle compared with the first state was 5% or lower, it was regarded as "good": or if it exceeded 5%, it was regarded as "poor".

Results were shown in Table 1.

**[Table 1]**

| | JOINT PART | PRESENCE OF BREAKAGE | CHANGE RATE OF RESISTANCE |
|---|---|---|---|
| EXAMPLE 1 | GOOD | NOT FOUND | GOOD |
| EXAMPLE 2 | GOOD | NOT FOUND | GOOD |
| COMPARATIVE EXAMPLE 1 | POOR | NOT FOUND | - |
| COMPARATIVE EXAMPLE 2 | GOOD | FOUND | - |

Regarding Comparative Example 1, there was no breakage on the ceramic substrates though, it was regarded as a bonding defect because there was a separation at the joint part between the electrode layers and the thermoelectric conversion elements. Regarding Comparative Example 2, a breakage was found on the ceramic substrates. Accordingly, both could not obtain an appropriate electric resistance value.

On the other, regarding Examples, there was no separation at the joint part, no breakage on the ceramic substrates, and so on; and deterioration (change of the electrical resistance) is small even after the cooling/heating cycle test: so that it is confirmed that high reliability can be maintained for a long term.

### Industrial Applicability

The thermoelectric conversion module can be utilized for a cooling device, a heating device, or a power generation device.

### Reference Signs List

- 1, 51: thermoelectric conversion module
- 2A, 2B: wiring substrate
- 3: P-type thermoelectric conversion element
- 4: N-type thermoelectric conversion element
- 5: case
- 6: higher-temperature channel
- 7: lower-temperature channel
- 8: heat sink
- 8a: fin
- 9: elastic member
- 11: ceramic substrate
- 12, 13: electrode layer
- 14: heat-transfer metal layer
- 15: outer wiring part
- 21: silver base layer
- 22: silver joint layer
- 23: glass layer
- 24: silver layer
- 25: metallized layer
- 60, 61: heat sink
- 65: heat source
- 70: liquid cooling cooler
- 81, 82: thermoelectric conversion device

## Claims

1. A thermoelectric conversion module (1) comprising:
a pair of opposing wiring substrates (2A,2B);
a plurality of thermoelectric conversion elements (3,4) connected via the wiring substrates between the wiring substrates;
ceramic substrates (11) provided at the respective wiring substrates (2A,2B);
electrode layers (12,13) made of aluminum or aluminum alloy, provided at the respective wiring substrates (2A,2B), formed on one surface of the respective ceramic substrates (11) and connected to the thermoelectric conversion elements (3,4); and
a silver base layer (21) formed on a surface of the electrode layers (12,13) at at least one of the wiring substrates (2A,2B), and connected to the thermoelectric conversion elements (3,4); wherein
the silver base layer (21) is structured from:
a glass layer (23) formed on any of the electrode layers (12,13); and
a silver layer (24) made of a fired body of silver laminated on the glass layer.

2. The thermoelectric conversion module (1) according to Claim 1, wherein metallized layers (25) made of any one of gold, silver or nickel are formed on the thermoelectric conversion elements (3,4) at each of end surfaces to which the electrode layers are joined.

3. The thermoelectric conversion module (1) according to Claim 2, wherein the silver base layer (21) is directly joined to the metallized layer (25) on the thermoelectric conversion element (3,4).

4. The thermoelectric conversion module (1) according Claim 2, further comprising, between the silver base layer (21) and the metallized layers (25) on the thermoelectric conversion element (3,4), a silver joint layer (22) made of a silver fired body joining the silver base layer (21) and the metallized layers (25).

5. The thermoelectric conversion module (1) according to Claim 2, wherein the metallized layers (25) are made of gold or silver, and barrier layers made of nickel or titanium are formed between the end surfaces of the thermoelectric conversion elements (3,4) and the metallized layers (25).

6. The thermoelectric conversion module (1) according to Claim 1, wherein the electrode layers are made of aluminum with purity 99.99 mass% or higher.

7. The thermoelectric conversion module (1) according to Claim 1, wherein heat-transfer metal layers (14) are joined on the other surfaces of the respective ceramic substrates (11).

8. A thermoelectric conversion module with heat sink comprising:
the thermoelectric conversion module (1) according to Claim 7;
an endothermic heat sink joined on the heat-transfer metal layer on one of the wiring substrates; and
a radiation heat sink joined on the heat transfer metal layer on the other of the wiring substrates.

9. A thermoelectric conversion device (82) comprising the thermoelectric conversion module (1) with heat sink according to Claim 8 and a liquid cooling cooler (70) fixed on the radiation heat sink.

## Patentansprüche

1. Modul zur thermoelektrischen Umwandlung (1), umfassend:
ein Paar gegenüberliegender Verdrahtungssubstrate (2A,2B);
eine Vielzahl von Elementen zur thermoelektrischen Umwandlung (3,4), die über die Verdrahtungssubstrate zwischen den Verdrahtungssubstraten verbunden sind;
Keramiksubstrate (11), die bei den jeweiligen Verdrahtungssubstraten (2A,2B) bereitgestellt sind;
Elektrodenschichten (12,13), die aus Aluminium oder Aluminiumlegierung hergestellt sind, bei den jeweiligen Verdrahtungssubstraten (2A,2B) bereitgestellt sind, an einer Fläche der jeweiligen Keramiksubstrate (11) gebildet sind und mit den Elementen zur thermoelektrischen Umwandlung (3,4) verbunden sind; und
eine Silberbasisschicht (21), die an einer Fläche der Elektrodenschichten (12,13) bei mindestens einem der Verdrahtungssubstrate (2A,2B) gebildet und mit den Elementen zur thermoelektrischen Umwandlung (3,4) verbunden ist; wobei
die Silberbasisschicht (21) strukturiert ist aus:
einer Glasschicht (23), die auf einer beliebigen der Elektrodenschichten (12,13) gebildet ist; und
eine Silberschicht (24), die aus einem gebrannten Silberkörper hergestellt ist, der auf die Glasschicht aufgeschichtet ist.

2. Modul zur thermoelektrischen Umwandlung (1) nach Anspruch 1, wobei metallisierte Schichten (25), die aus einem beliebigen von Gold, Silber oder Nickel hergestellt sind, auf den Elementen zur thermoelektrischen Umwandlung (3,4) bei jeder von Endflächen gebildet sind, mit denen die Elektrodenschichten verbunden sind.

3. Modul zur thermoelektrischen Umwandlung (1) nach Anspruch 2, wobei die Silberbasisschicht (21) direkt mit der metallisierten Schicht (25) auf dem Element zur thermoelektrischen Umwandlung (3,4) verbunden ist.

4. Modul zur thermoelektrischen Umwandlung (1) nach Anspruch 2, weiter umfassend, zwischen der Silberbasisschicht (21) und den metallisierten Schichten (25) auf dem Element zur thermoelektrischen Umwandlung (3,4), eine Silberverbindungsschicht (22), die aus einem silbergebrannten Körper hergestellt ist, der die Silberbasisschicht (21) und die metallisierten Schichten (25) verbindet.

5. Modul zur thermoelektrischen Umwandlung (1) nach Anspruch 2, wobei die metallisierten Schichten (25) aus Gold oder Silber hergestellt sind und Sperrschichten, die aus Nickel oder Titan hergestellt sind, zwischen den Stirnflächen der Elemente zur thermoelektrischen Umwandlung (3,4) und den metallisierten Schichten (25) gebildet sind.

6. Modul zur thermoelektrischen Umwandlung (1) nach Anspruch 1, wobei die Elektrodenschichten aus Aluminium mit einer Reinheit von 99,99 Masseprozent oder höher hergestellt sind.

7. Modul zur thermoelektrischen Umwandlung (1) nach Anspruch 1, wobei Wärmeübertragungsmetallschichten (14) an den anderen Flächen der jeweiligen Keramiksubstrate (11) verbunden sind.

8. Modul zur thermoelektrischen Umwandlung mit Kühlkörper, umfassend:
das Modul zur thermoelektrischen Umwandlung (1) nach Anspruch 7;
einen endothermen Kühlkörper, der an der Wärmeübertragungsmetallschicht auf einem der Verdrahtungssubstrate verbunden ist; und
einen Strahlungskühlkörper, der an der Wärmeübertragungsmetallschicht auf der anderen der Verdrahtungssubstrate verbunden ist.

9. Vorrichtung zur thermoelektrischen Umwandlung (82), umfassend das Modul zur thermoelektrischen Umwandlung (1) mit Kühlkörper nach Anspruch 8 und einem Kühler zum Flüssigkeitskühlen (70), der am Strahlungskühlkörper befestigt ist.

## Revendications

1. Module de conversion thermoélectrique (1) comprenant :
une paire de substrats de câblage opposés (2A,2B) ;
une pluralité d'éléments de conversion thermoélectrique (3,4) connectés via les substrats de câblage entre les substrats de câblage ;
des substrats en céramique (11) prévus au niveau des substrats de câblage (2A,2B) respectifs ;
des couches d'électrode (12,13) constituées d'aluminium ou d'alliage d'aluminium, prévues au niveau des substrats de câblage (2A,2B) respectifs, formées sur une surface des substrats en céramique (11) respectifs et connectées aux éléments de conversion thermoélectrique (3,4) ; et
une couche de base d'argent (21) formée sur une surface des couches d'électrode (12,13) au niveau d'au moins un des substrats de câblage (2A,2B), et connectée aux éléments de conversion thermoélectrique (3,4) ; dans lequel
la couche de base d'argent (21) est structurée à partir :
d'une couche de verre (23) formée sur l'une quelconque des couches d'électrode (12,13) ; et
d'une couche d'argent (24) constituée d'un corps cuit d'argent stratifié sur la couche de verre.

2. Module de conversion thermoélectrique (1) selon la revendication 1, dans lequel des couches métallisées (25) constituées de l'un quelconque parmi or, argent ou nickel sont formées sur les éléments de conversion thermoélectrique (3,4) au niveau de chacune des surfaces d'extrémité auxquelles sont jointes les couches d'électrode.

3. Module de conversion thermoélectrique (1) selon la revendication 2, dans lequel la couche de base d'argent (21) est jointe directement à la couche métallisée (25) sur l'élément de conversion thermoélectrique (3,4).

4. Module de conversion thermoélectrique (1) selon la revendication 2, comprenant en outre, entre la couche de base d'argent (21) et les couches métallisées (25) sur l'élément de conversion thermoélectrique (3,4), une couche de joint d'argent (22) constituée d'un corps cuit d'argent joignant la couche de base d'argent (21) et les couches métallisées (25).

5. Module de conversion thermoélectrique (1) selon la revendication 2, dans lequel les couches métallisées (25) sont constituées d'or ou d'argent, et des couches barrières constituées de nickel ou de titane sont formées entre les surfaces d'extrémité des éléments de conversion thermoélectrique (3,4) et les couches métallisées (25).

6. Module de conversion thermoélectrique (1) selon la revendication 1, dans lequel les couches d'électrode sont constituées d'aluminium ayant une pureté de 99,99 % en masse ou plus.

7. Module de conversion thermoélectrique (1) selon la revendication 1, dans lequel des couches métalliques de transfert de chaleur (14) sont jointes sur les autres surfaces des substrats en céramique (11) respectifs.

8. Module de conversion thermoélectrique avec dissipateur de chaleur comprenant :
le module de conversion thermoélectrique (1) selon la revendication 7 ;
un dissipateur de chaleur endothermique joint sur la couche métallique de transfert de chaleur sur un des substrats de câblage ; et
un dissipateur de chaleur de rayonnement joint sur la couche métallique de transfert de chaleur sur l'autre des substrats de câblage.

9. Dispositif de conversion thermoélectrique (82) comprenant le module de conversion thermoélectrique (1) avec dissipateur de chaleur selon la revendication 8 et un refroidisseur de refroidissement de liquide (70) fixé sur le dissipateur de chaleur de rayonnement.
